# EUROPEAN PATENT APPLICATION

(11) **EP 4 518 626 A2**
(43) Date of publication of application: **05.03.2025**
(21) Application number: 24197456.7
(22) Date of filing: 30.08.2024
(51) Int. Cl.: H10K 59/123, G03G 15/04, H10K 59/131, H10K 59/80, H10K 50/842, H10K 71/16

(54) **LIGHT EMITTING APPARATUS, MANUFACTURING METHOD THEREOF, AND IMAGE FORMING APPARATUS**

(30) Priority: 31.08.2023 JP 2023141383; 16.10.2023 JP 2023178387; 10.06.2024 JP 2024093862
(71) Applicant: CANON KABUSHIKI KAISHA, Tokyo 146-8501 (JP)
(72) Inventor: MASHIMO, Seiji, Tokyo (JP); OKITA, Akira, Tokyo (JP); MIURA, Seishi, Tokyo (JP); MOCHIZUKI, Hiroyuki, Tokyo (JP); GOMMORI, Eisuke, Tokyo (JP); RYOKI, Tatsuya, Tokyo (JP); NAGASAKI, Mizuki, Tokyo (JP)
(74) Representative: WESER & Kollegen Patentanwälte PartmbB

(57) **Abstract**

A light emitting apparatus (2) includes a polygonal substrate (RS) having first and second sides (S1, S2) parallel to a first direction and third and fourth sides (S3, S4) parallel to a second direction, a light emitting element array (3), a pad (8) arranged on the substrate to be located between the first side (S1) and the light emitting element array (2), and a moisture-resistant ring (70) structure arranged on the substrate. The moisture-resistant ring structure (70) includes a moisture-resistant wall arranged between the light emitting element array (2) and the first side (S1). A shortest distance between the light emitting element array (2) and the moisture-resistant wall in the second direction is smaller than a distance between the light emitting element array (2) and the moisture-resistant wall on a virtual straight line parallel to the second direction and passing through the light emitting element array (2) and the pad (8).

## Description

### BACKGROUND OF THE INVENTION

### Field of the Invention

The present disclosure relates to a light emitting apparatus, a manufacturing method thereof, and an image forming apparatus.

### Description of the Related Art

There is available a light emitting apparatus having a plurality of functional layers, such as a hole injection layer, a hole transport layer, a light emitting layer, an electron transport layer, and an electron injection layer, formed in a deposition process using a deposition mask. The deposition mask has a plurality of openings. In the deposition process, functional layer materials can be deposited on a substrate through the plurality of openings. On the other hand, in order to prevent the infiltration of moisture into a light emitting element having a plurality of functional layers, the light emitting apparatus can be provided with a moisture-resistant ring. Japanese Patent Laid-Open No. 2018-29070 discloses a light emitting apparatus having a rectangular guard ring.

A deposition mask can have protrusions called ribs or the like to maintain the gap constant between the pattern portion of the deposition mask and the material substrate. In the deposition process, the deposition mask can be arranged so as to bring the protrusions into contact with the contact permitted area of the material substrate (the area that permits contact of the protrusions). When the contact permitted area is arranged outside the moisture-resistant ring, the adjacent light emitting apparatuses on the material substrate are separated from each other through the contact permitted areas. Accordingly, this limits the number of light emitting apparatuses that can be obtained from one substrate. This can then increase the manufacturing cost of the light emitting apparatuses.

### SUMMARY OF THE INVENTION

One aspect of the present disclosure provides a technique advantageous in reducing the manufacturing cost of a light emitting apparatus having a moisture-resistant ring structure.

The present invention in its first aspect provides a light emitting apparatus as specified in claims 1 to 14.

The present invention in its second aspect provides an image forming apparatus as specified in claim 15.

The present invention in its third aspect provides a manufacturing method of a light emitting apparatus, as specified in claims 16 to 20.

Further features of the present invention will become apparent from the following description of exemplary embodiments with reference to the attached drawings.

### BRIEF DESCRIPTION OF THE DRAWINGS

Fig. 1 is a plan view schematically showing a plurality of light emitting apparatuses in the process of manufacture arranged on a material substrate;
Fig. 2 is a plan view exemplifying a deposition mask;
Fig. 3 is an enlarged plan view of part of the deposition mask in Fig. 2;
Fig. 4 is a sectional view schematically showing a material substrate and a deposition mask stacked on each other;
Fig. 5 is a plan view exemplifying another deposition mask;
Fig. 6 is a plan view schematically showing the arrangement of a light emitting apparatus according to the first embodiment;
Fig. 7 is a sectional view schematically showing a section taken along line B - B' in Fig. 6;
Fig. 8 is a sectional view schematically showing a section taken along line C - C' in Fig. 6;
Fig. 9 is a plan view schematically showing the arrangement of a light emitting apparatus according to a comparative example;
Fig. 10 is a plan view schematically showing the arrangement of a light emitting apparatus according to the second embodiment;
Fig. 11 is a plan view schematically showing the arrangement of a light emitting apparatus according to the third embodiment;
Fig. 12 is a view schematically showing the arrangement of an image forming apparatus according to an embodiment;
Fig. 13 is a view exemplifying the array of a plurality of light emitting apparatuses;
Fig. 14 is a view for explaining a modification of the light emitting apparatuses according to the first to third embodiments;
Fig. 15 is a sectional view schematically showing a section taken along line D - D' in Fig. 6;
Figs. 16A to 16C are views showing the placement of a substrate and the placement of a deposition mask for a light emitting apparatus according to the fourth embodiment;
Fig. 17 is a sectional view showing an example of the light emitting apparatus according to the fourth embodiment;
Fig. 18 is a plan view showing an example of the light emitting apparatus according to the fourth embodiment;
Fig. 19 is an example of a sectional view at E - E' plane in Fig. 18;
Fig. 20 is a plan view showing an example of a light emitting apparatus according to the fifth embodiment;
Fig. 21 is a plan view showing an example of a light emitting apparatus according to the sixth embodiment; and
Fig. 22 is an example of sectional view at F - F' plane in Fig. 21.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

The structure of a light emitting apparatus 2 and a manufacturing method thereof according to the first embodiment will be exemplarily described below. Numerical values, shapes, materials, constituent elements, placement and connection forms of constituent elements, and the like are not intended to limit the disclosure range unless explicitly specified otherwise. The light emitting apparatus 2 can be manufactured by processing a material substrate such as a silicon wafer. In this specification, in order to prevent a complicated explanation, a light emitting apparatus in the process of manufacture will sometimes be described as a light emitting apparatus. In addition, in the specification and the accompanying drawings, directions will be described in accordance with the XYZ coordinate system. In this case, the XYZ coordinate system is defined such that the principal surface of a material substrate or light emitting apparatus is parallel to an XY plane. For the sake of descriptive convenience, in the following description, the X direction is defined as the first direction, and the Y direction is defined as the second direction orthogonal to the first direction. For example, the Y direction and the X direction may be respectively defined as the first direction and the second direction. In the following description, a plan view is synonymous with a planar view or an orthogonal projection to an XY plane.

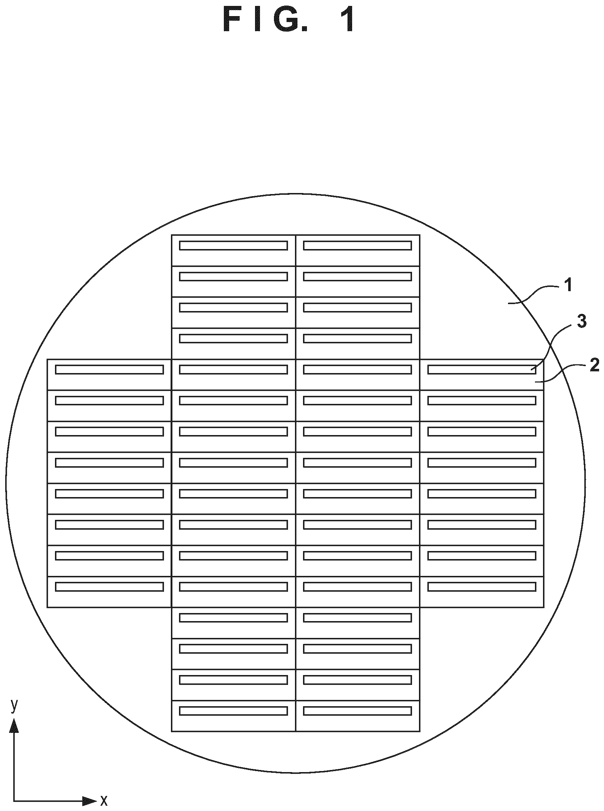

Fig. 1 schematically shows a plurality of light emitting apparatuses 2 in the process of manufacture arranged on a material substrate 1 such as a silicon wafer. Each light emitting apparatus 2 is provided with a light emitting element array 3 or the light emitting element array 3 is defined. That the light emitting element array 3 being defined means that although a region in which the light emitting element array 3 is planned to be formed is defined, the light emitting element array 3 has not been completed. The completed light emitting element array 3 has a plurality of light emitting elements. The light emitting element array 3 or a plurality of light emitting elements can include a plurality of first electrodes that can be individually controlled, organic films arranged on the plurality of first electrodes, and second electrodes arranged on the organic films. For example, the organic film and the second electrode can be shared by a plurality of light emitting elements. The organic film can be composed of a plurality of functional layers. Each of the plurality of functional layers can be composed of an organic material. In another aspect, each of the plurality of light emitting elements can include a hole injection layer, a hole transport layer, an organic light emitting layer, an electron transport layer, and an electron injection layer.

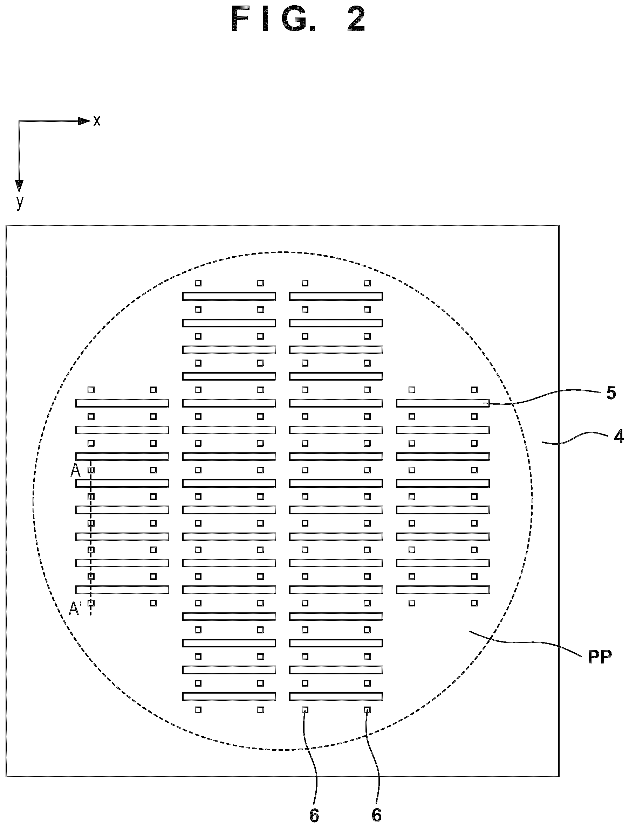

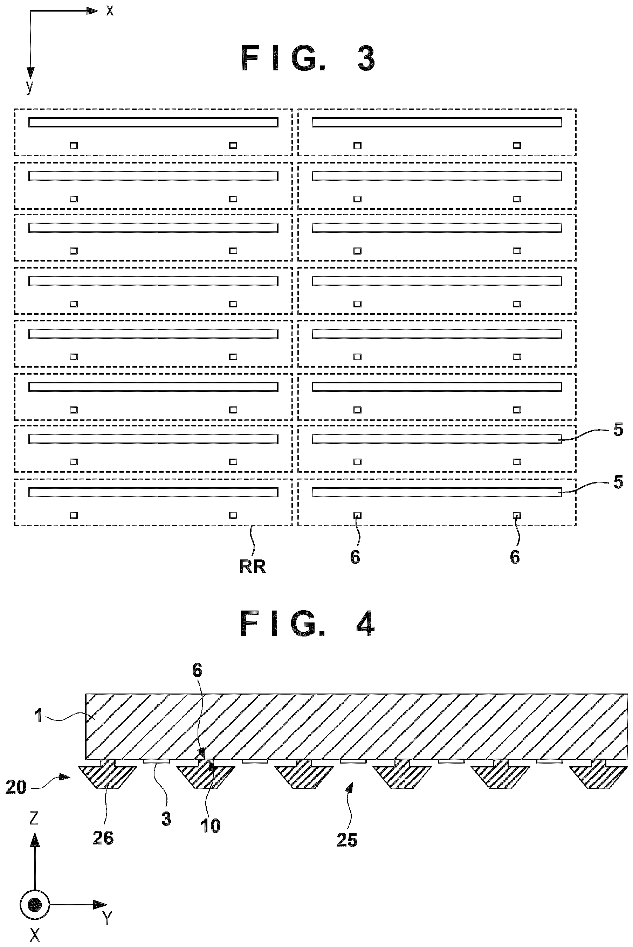

Fig. 2 schematically shows a deposition mask 4 for manufacturing the plurality of light emitting apparatuses 2. The geometric figure or circle indicated by the dotted line in Fig. 2 indicates a region in which the material substrate 1 is arranged. Fig. 3 is an enlarged view of part of Fig. 2. In this case, the deposition mask 4 shown in Figs. 2 and 3 can be used to form a plurality of organic films on the light emitting element array 3 of each light emitting apparatus 2 by vapor deposition. Fig. 4 schematically shows the material substrate 1 and the deposition mask 4 stacked on each other. Fig. 4 corresponds to the section taken along line A - A' in Fig. 2. The deposition mask 4 has a pattern portion PP having a plurality of rectangular substrate regions RR respectively corresponding to the plurality of light emitting apparatuses 2 and a plurality of protrusions 6. Each rectangular substrate region RR can have one opening 5 for the formation of an organic film. Note that each rectangular substrate region RR may have a plurality of openings 5. In a deposition process, a material gas emitted from a material gas supply source can be provided to the material substrate 1 through each opening 5.

The material substrate 1 or the plurality of light emitting apparatuses 2 in the process of manufacture has contact permitted areas 10 as areas with which the protrusions 6 of the deposition mask 4 are permitted to come into contact. The contact permitted area 10 is typically an area of part of the upper surface of a layer stacked on the material substrate 1. In this case, for the sake of simplicity, such an area is also expressed as the contact permitted area 10 of the material substrate 1. Each light emitting apparatus 2 in the process of manufacture can have at least one contact permitted area 10, preferably at least two contact permitted areas 10.

The deposition mask 4 does not come into contact with the material substrate 1 (and the layer stacked on the material substrate 1) except for the contact permitted areas 10 to which the protrusions 6 correspond. Bringing the protrusions 6 of the deposition mask 4 into contact with the contact permitted areas 10 of the material substrate 1 will define the gap between the material substrate 1 and the pattern portion PP of the deposition mask 4. Such a scheme is advantageous in arranging the material substrate 1 and the pattern portion PP close to each other while maintaining the accurate gap between the material substrate 1 and the pattern portion PP of the deposition mask 4. This is advantageous in suppressing deposition to unnecessary regions and is further advantageous in downsizing each light emitting apparatus 2. A trace of the contact of the pattern portion PP as part of the deposition mask 4 can be formed on the contact permitted area 10 in a manufacturing process of the light emitting apparatus 2. Such a trace can be, for example, a flaw.

A magnet can be used to fix the deposition mask 4 to the material substrate 1. In this case, the deposition mask 4 can be formed from a magnetic material such as invar. Alternatively, to fix the deposition mask 4 to the material substrate 1, a pressurizing mechanism or the like which presses the deposition mask 4 against the material substrate 1 may be used.

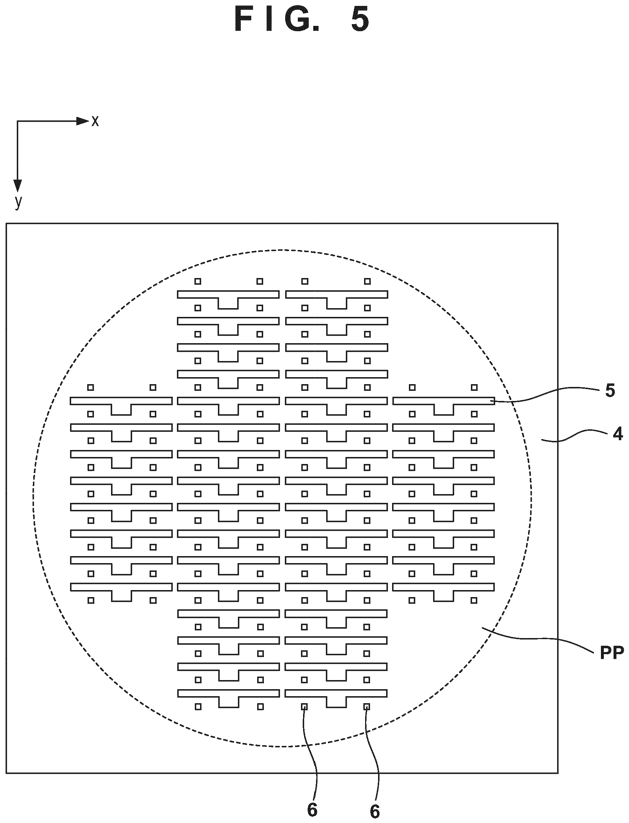

After organic films (a plurality of functional layers) are formed on the light emitting element array 3 by using the deposition mask 4 shown in Figs. 2 and 3, a second electrode can be formed by using the deposition mask 4 schematically shown in Fig. 5. The geometric figure or circle indicated by the dotted line in Fig. 5 indicates a region in which the material substrate 1 is arranged. The deposition mask 4 has the pattern portion PP having the plurality of rectangular regions RR respectively corresponding to the plurality of light emitting apparatuses 2 and the plurality of protrusions 6. Each rectangular substrate region RR can have one opening 5 for the formation of a second electrode. After the plurality of second electrodes are formed, a protective film can be formed on the entire area of the material substrate 1 so as to cover the plurality of second electrodes of the material substrate 1. This makes it possible to suppress the infiltration of moisture into organic films (a plurality of functional layers).

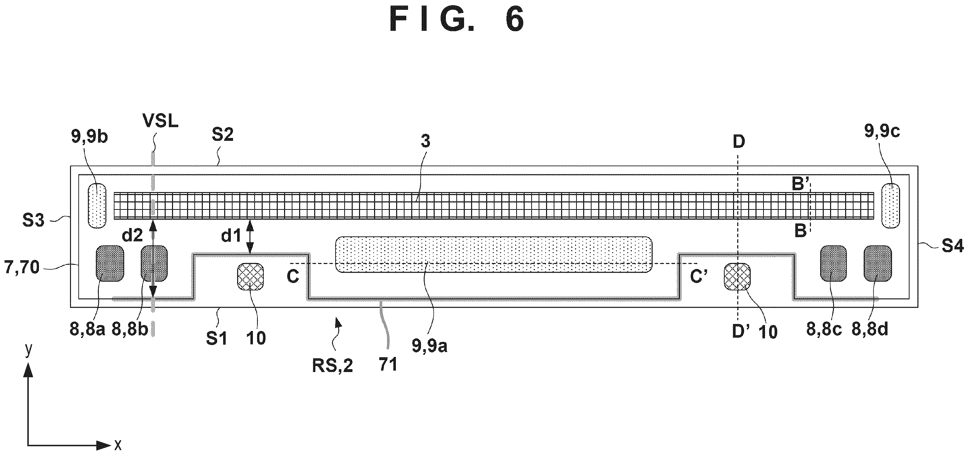

Fig. 6 schematically shows the arrangement of one light emitting apparatus 2. The light emitting apparatus 2 has a rectangular substrate RS having a first side S1 and a second side S2, which are parallel to the X direction (first direction), and a third side S3 and a fourth side S4, which are parallel to the Y direction (second direction) orthogonal to the X direction (first direction). The rectangular substrate RS is part of the material substrate 1, more specifically, a portion chipped from the material substrate 1 by dicing. The light emitting apparatus 2 can also include the light emitting element array 3 composed of a plurality of light emitting elements arranged on the rectangular substrate RS and one or a plurality of pads 8 arranged on the rectangular substrate RS so as to be located between the first side S1 and the light emitting element array 3. The light emitting apparatus 2 can also include a moisture-resistant ring structure 70 arranged on the rectangular substrate RS so as to suppress the infiltration of moisture into the light emitting element array 3 and all the pads 8. The pads may be connected to external circuits. Although the following exemplifies a rectangular substrate as a substrate, the shape of the substrate is not limited to this as long as it is polygonal in planar view. In this case, polygonal substrates may include substantially polygonal substrates and may be a polygonal substrate or a rectangular substrate with round corners having curved lines. In addition, light emitting regions and moisture-resistant rings may have polygonal shapes other than rectangular shapes.

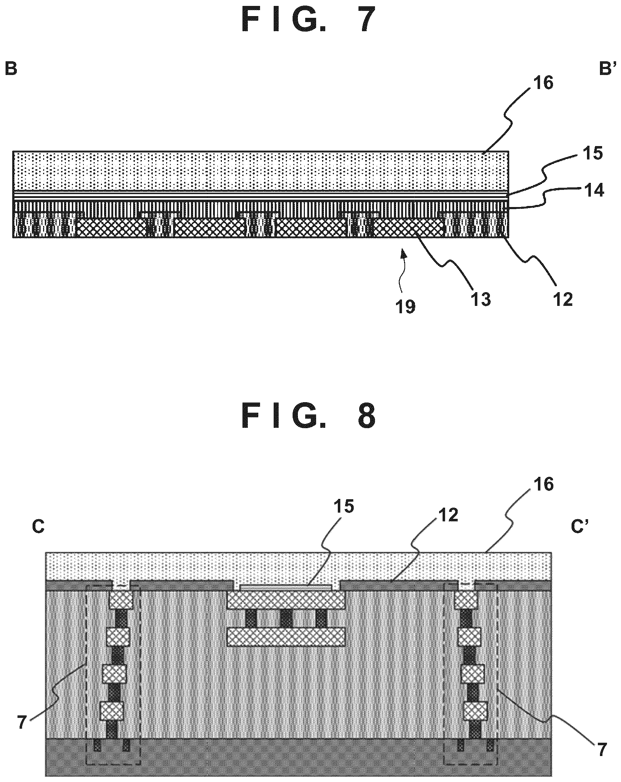

The moisture-resistant ring structure 70 can include a moisture-resistant wall 71 arranged between the light emitting element array 3 and the first side S1. Referring to Fig. 6, the moisture-resistant wall 71 of the moisture-resistant ring structure 70 is indicated by the thick gray line. The shortest distance between the light emitting element array 3 and the moisture-resistant wall 71 in the Y direction (second direction) is a distance d1. The distance between the light emitting element array 3 and the moisture-resistant wall 71 on a virtual straight line VSL parallel to the Y direction (second direction) and passing through the light emitting element array 3 and the pad 8 is a distance d2. In the first embodiment, the distance d1 is smaller than the distance d2. This reduces the distance (interval) between the adjacent light emitting apparatuses 2 on the material substrate 1 in the Y direction and increases the number of light emitting apparatuses 2 that can be formed on the material substrate 1, and hence is advantageous in reducing the manufacturing cost of the light emitting apparatuses 2. The distance d1 may be a shortest distance between the moisture-resistant wall 71 and the first electrode 13 (Fig. 7) of the light emitting element which is closest to the moisture-resistant wall 71 in the Y direction among the light emitting element array 3. The distance d2 may be a shortest distance between the pad 8 and the first electrode 13 of the light emitting element which is closest to the moisture-resistant wall 71 on the virtual straight line VSL among the light emitting element array 3.

The moisture-resistant ring structure 70 can include a first moisture-resistant ring 7 arranged so as to surround the light emitting element array 3 and the pads 8. The moisture-resistant wall 71 can be part of the first moisture-resistant ring 7. The first moisture-resistant ring 7 can be arranged so as to entirely circumferentially surround the light emitting element array 3.

The light emitting apparatus 2 can further include a plurality of contact regions 9 arranged on the rectangular substrate RS so as to receive signals or potentials for driving the plurality of light emitting elements of the light emitting element array 3. The plurality of contact regions 9 can be electrically connected to the second electrodes of the plurality of light emitting elements. The moisture-resistant ring structure 70 can be arranged on the rectangular substrate RS so as to suppress the infiltration of moisture into the plurality of contact regions 9 in addition to the light emitting element array 3 and the plurality of pads 8. More specifically, the first moisture-resistant ring 7 of the moisture-resistant ring structure 70 can be arranged on the rectangular substrate RS so as to surround the light emitting element array 3, the plurality of pads 8, and the plurality of contact regions 9. The first moisture-resistant ring 7 is preferably arranged on the rectangular substrate RS so as to entirely circumferentially surround the light emitting element array 3, the plurality of pads 8, and the plurality of contact regions 9.

The minimum rectangle (virtual minimum rectangle) circumscribed to the light emitting element array 3 is preferably larger in size in the X direction (first direction) than in the Y direction (second direction). For example, the minimum rectangle (virtual minimum rectangle) circumscribed to the light emitting element array 3 can be two or more times, three or more times, or five or more times larger in size in the X direction (first direction) than in the Y direction (second direction).

The plurality of contact regions 9 can include a first contact region 9a, a second contact region 9b, and a third contact region 9c. The first contact region 9a is arranged between the light emitting element array and the first side S1, the second contact region 9b is arranged between the light emitting element array 3 and the third side S3, and the third contact region 9c is arranged between the light emitting element array 3 and the fourth side S4. Referring to Fig. 6, in order to discriminate the plurality of contact regions 9 from each other, the respective regions are assigned with reference numerals 9a, 9b, and 9c together with reference numeral 9. In addition, referring to Fig. 6, in order to discriminate the plurality of pads 8 from each other, the respective pads are assigned with reference numeral 8a, 8b, 8c, and 8d together with reference numeral 8. For example, a portion of the moisture-resistant wall 71 which defines the shortest distance d1 can be arranged between the first pad 8b and the first contact region 9a on the virtual straight line VSL. The plurality of pads 8 can include the second pad 8c arranged on the rectangular substrate RS so as to be located between the first side S1 and the light emitting element array 3 in addition to the first pad 8b on the virtual straight line VSL. A portion of the moisture-resistant wall 71 which defines the shortest distance d1 can be arranged between the first pad 8b and the second pad 8c.

Fig. 7 schematically shows a section taken along line B - B' in Fig. 6. Referring to Fig. 7, however, an illustration of constituent elements arranged below a first electrode 13 of a light emitting element 19 forming the light emitting element array 3 is omitted. The light emitting element 19 can include the first electrode 13, an organic film 14 arranged on the first electrode 13, and a second electrode 15 arranged on the organic film 14. The organic film 14 can include a plurality of functional layers. The first electrode 13 is an independent electrode provided on each light emitting element 19. The second electrode 15 can be a common electrode commonly provided for the plurality of light emitting elements 19.

Light generated by the light emitting element 19 passes through the second electrode 15 and emitted from the light emitting apparatus 2. Accordingly, the second electrode 15 is formed from a transparent or semitransparent layer. The second electrode 15 is formed from a thin film made of a metal material and can have a relatively high wiring resistance. If the light emitting element array 3 has a shape long in the X direction and the contact region 9 is arranged only in the longitudinal direction of the light emitting element array 3, shading occurs, that is, luminance changes with an increase in distance from the contact region 9 due to a voltage drop at the second electrode 15. For a countermeasure against such a problem, as exemplarily shown as the contact region 9a in Fig. 6, the contact regions 9 corresponding in number to the length of the light emitting element array 3 in the longitudinal direction can be arranged in a proper place in the longitudinal direction.

Fig. 8 schematically shows a section taken along line C - C' in Fig. 6. The first moisture-resistant ring 7 can be formed by, for example, stacking a contact plug and a metal wiring. The surface of the first moisture-resistant ring 7 is covered with a protective layer 16 to suppress the infiltration of moisture from the outside of the first moisture-resistant ring 7 into the inner region (including the light emitting element array 3).

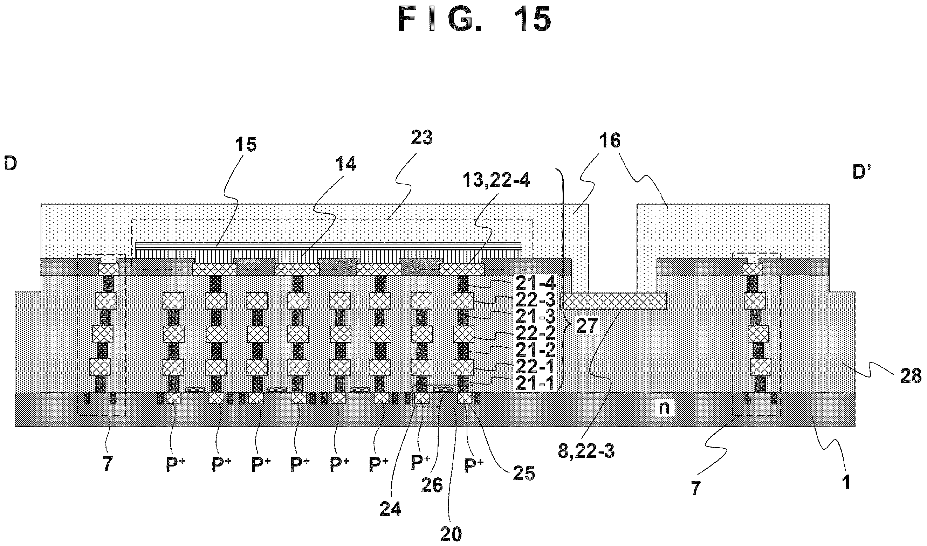

Fig. 15 schematically shows a section taken along line D - D' in Fig. 6. Fig. 15 schematically shows an example of a light emitting element 23 and an example of a transistor 20 connected to the light emitting element 23. The transistor 20 is an example of a functional element. The transistor 20 may be a thin film transistor (TFT).

A drain 25 and a source 24 of the transistor 20 are arranged on the material substrate 1. A gate 26 of the transistor 20 is arranged on the material substrate 1 through a gate insulating film (not shown).

A wiring 27 is composed of a plurality of contact plugs 21_1 to 22_4 and a plurality of metal wirings 22_1 to 22_4 which electrically connect the drain 25 of the transistor 20 to the light emitting element 23. An insulating layer 28 is provided between the wirings. Although Fig. 15 shows the insulating layer 28 as if it were a single layer, the insulating layer 28 may have a multilayer structure composed of a plurality of layers.

The light emitting element 23 can be composed of the first electrode 13, the organic film 14 having a light emitting layer, and the second electrode 15. Although Fig. 15 shows the organic film 14 as if it were a single layer, the organic film 14 may be composed of a plurality of layers. In the light emitting element 23, the organic film 14 is a transparent electrode, and light from the organic film 14 is extracted to the outside through the second electrode 15. The protective layer 16 is provided on the second electrode 15 to reduce a deterioration in the light emitting element 23. The second electrode 15 of the light emitting element 23 is shared by the plurality of light emitting elements 23 and serves as a common electrode.

In the light emitting element array, constituent units composed of combinations of the light emitting elements 23 and the transistors 20 can be repeatedly arranged in the row and column directions. A scheme of electrically connecting the light emitting element 23 to the electrodes (source and drain electrodes) included in the transistor 20 is not limited to the mode shown in Fig. 15. It is at least required to electrically connect one of the source and drain electrodes of the transistor 20 to the first electrode 13 of the light emitting element 23 in accordance with the polarity of the first electrode 13 of the light emitting element 23 and the polarity of the transistor 20. Referring to Fig. 15, although a transistor is used as a switching element, another switching element may be used instead of the transistor.

In addition, the transistor 20 is not limited to the transistor formed on a single crystal silicon wafer and may be a thin film transistor having an active layer on the insulating surface of a substrate. Examples of the active layer are single crystal silicon, non-single crystal silicon such as amorphous silicon and microcrystal silicon, and non-single crystal oxide semiconductors such as indium zinc oxide and indium gallium zinc oxide.

In addition, the moisture-resistant ring 7 is in physical contact with the protective layer 16 of the light emitting element 23. This reduces or prevents the infiltration of moisture from the outside into the light emitting element 23. Furthermore, at least one of the plurality of plurality of contact plugs 21_1 to 22_4 and the plurality of metal wirings 22_1 to 22_4 forming the moisture-resistant ring 7 may be partly replaced with a layer made of the same material as that of the protective layer 16. Since the protective layer 16 is formed from a material that can reduce the infiltration of moisture, even such replacement can maintain the moisture resistance of the moisture-resistant ring 7. In this embodiment, a structure having such replacement is also called a moisture-resistant ring.

In the example shown in Fig. 6, the contact permitted areas 10 with which the protrusions 6 of the deposition mask 4 come into contact are provided at two positions. Accordingly, in planar view (plan view) like that shown in Fig. 6, the moisture-resistant wall 71 forming part of the first moisture-resistant ring 7 has concave portions so as to recede from the first side S1 at the two positions. The contact permitted areas 10 are arranged in these concave portions. There are no constituent elements such as a pad, a driving circuit, and a contact region in the contact permitted area 10. Extending the contact permitted area 10 within a possible range will narrow the protection region surrounded by the first moisture-resistant ring 7 and reduce the possibility of the occurrence of a defect in the protection region, thereby improving the reliability of the light emitting apparatus 2. Note that an example of a defect that can occur in the protection region is the infiltration of moisture due to a damage to the protective layer 16 on the protection region.

The pattern portion PP of the deposition mask 4 is arranged apart from the material substrate 1 by the protrusions 6. If the gap between the pattern portion PP and the material substrate 1 (the height of the protrusions 6) is excessively large, a film can be formed on the material substrate 1 throughout a range wider than the opening 5 of the pattern portion PP by vapor deposition. Accordingly, the gap between the pattern portion PP and the material substrate 1 (the height of the protrusions 6) is preferably 20 µm or less, and more preferably 10 µm or less. The minimum value of the gap between the pattern portion PP and the material substrate 1 (the height of the protrusions 6) can be determined so as to guarantee that the pattern portion PP does not come into contact with the material substrate 1.

The interval of the adjacent protrusions 6 can also be considered. If the interval between the adjacent protrusions 6 is too large, at between the protrusions 6 a portion the pattern portion PP of the deposition mask 4 can come into contact with the material substrate 1. Table 1 exemplarily shows the results of checking whether the pattern portion PP comes into contact with the material substrate 1 while the intervals of the protrusions 6 and the thickness (layer thickness) of the pattern portion are changed. The height of the protrusion 6 was set to 10 µm, the magnetic force for fixing the deposition mask 4 to the material substrate 1 was set to 150 Gauss, and the intervals of the openings 5 was set to 250 µm. Contact between the pattern portion PP and the material substrate 1 was evaluated by measuring, by a particle counter, particles on areas other than the contact permitted areas 10 of the material substrate 1 after the contact of the protrusions 6 of the deposition mask 4 with the material substrate 1. In this case, when there was no particle, "no contact" (NC) is determined, whereas when there was a particle, "contact" (C) was determined.

**[Table 1]**

| Layer Thickness (mm) | Intervals of Protrusions (mm) | | | | | | | | |
|---|---|---|---|---|---|---|---|---|---|
| | 2 | 5 | 10 | 12 | 15 | 20 | 25 | 30 | 35 |
| 0.1 | NC | NC | NC | C | C | C | C | C | C |
| 0.2 | NC | NC | NC | NC | NC | C | C | C | C |
| 0.3 | NC | NC | NC | NC | NC | NC | C | C | C |
| 0.5 | NC | NC | NC | NC | NC | NC | NC | NC | C |

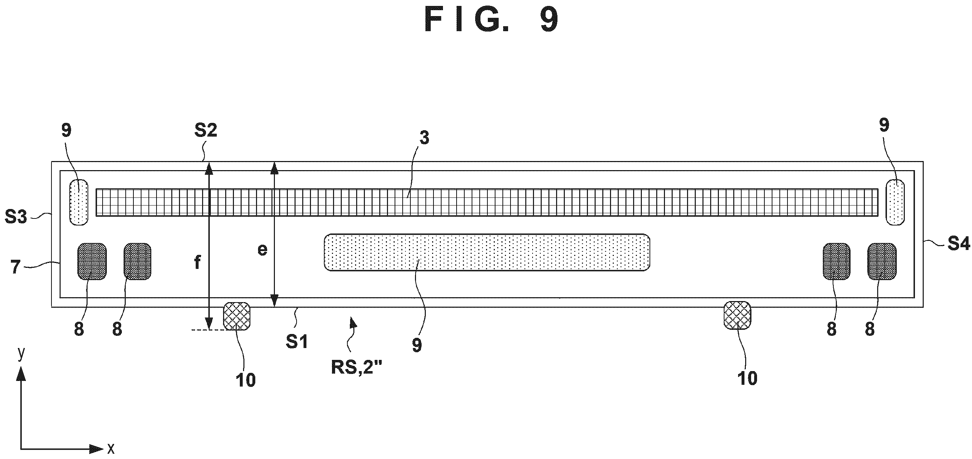

Fig. 9 shows the arrangement of a light emitting apparatus 2" according to a comparative example. The light emitting apparatus 2" according to the comparative example has a rectangular moisture-resistant ring 7. Contact permitted areas 10 are arranged outside the moisture-resistant ring 7. In this arrangement, a size f of a unit constituted by the light emitting apparatus 2" and the contact permitted areas 10 in the Y direction (second direction) is larger than a size e of the light emitting apparatus 2" in the Y direction. This may reduce the number of light emitting apparatuses 2" obtained from one material substrate 1.

A manufacturing method for manufacturing the light emitting apparatus 2 according to the first embodiment can have a deposition process of depositing the formation materials of functional layers on the material substrate 1 having a plurality of rectangular substrate regions each serving as the rectangular substrate RS by using the deposition mask 4. Each of the plurality of rectangular substrate regions of the material substrate 1 has the contact permitted area 10 between the first side S1 and a portion of the moisture-resistant wall 71 which defines the shortest distance d1. The deposition mask 4 can include the plurality of protrusions 6 which respectively come into contact with the contact permitted areas 10 in the plurality of rectangular substrate regions and the pattern portion PP having the plurality of openings 5. In a deposition process, the plurality of protrusions 6 define the distance between the material substrate 1 and the pattern portion PP.

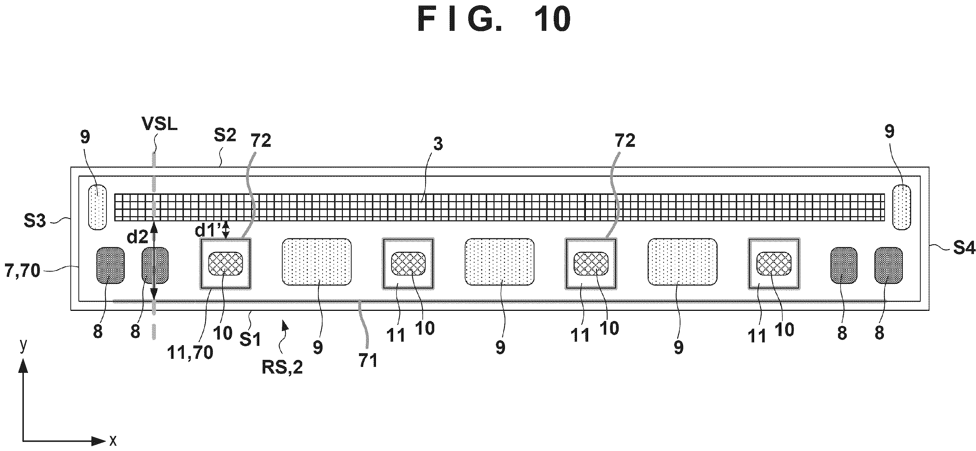

A light emitting apparatus 2 according to the second embodiment will be described below with reference to Fig. 10. Fig. 10 schematically shows the arrangement of one light emitting apparatus 2 according to the second embodiment. Note that matters that are not referred to in the second embodiment can comply with the first embodiment unless any contradiction occurs.

The light emitting apparatus 2 can include a moisture-resistant ring structure 70 that is arranged in a rectangular substrate RS so as to suppress the infiltration of moisture into a light emitting element array 3 and all pads 8. The moisture-resistant ring structure 70 can include moisture-resistant walls 71 and 72 arranged between the light emitting element array 3 and a first side S1. Referring to Fig. 10, the moisture-resistant walls 71 and 72 of the moisture-resistant ring structure 70 are indicated by the thick gray lines. The shortest distance between the light emitting element array 3 and the moisture-resistant walls 71 and 72 in the Y direction (second direction) is a distance d1'. The distance between the light emitting element array 3 and the moisture-resistant wall 71 on a virtual straight line VSL parallel to the Y direction (second direction) and passing through the light emitting element array 3 and the pad 8 is a distance d2. In the second embodiment, the distance d1' is smaller than the distance d2. This reduces the distance (interval) between the adjacent light emitting apparatuses 2 on the material substrate 1 in the Y direction and increases the number of light emitting apparatuses 2 that can be formed on a material substrate 1, and hence is advantageous in reducing the manufacturing cost of the light emitting apparatuses 2.

The moisture-resistant ring structure 70 can include a first moisture-resistant ring 7 arranged so as to surround the light emitting element array 3 and the pads 8 and a second moisture-resistant ring 11 arranged so as not to surround the light emitting element array 3 and the pads 8 and so as to be surrounded by the first moisture-resistant ring 7. The first moisture-resistant ring 7 can include a portion that defines the distance d2 between the light emitting element array 3 and the moisture-resistant walls 71 and 72 on the virtual straight line VSL. The second moisture-resistant ring 11 can include a portion that defines the shortest distance d1' between the light emitting element array 3 and the moisture-resistant walls 71 and 72. The first moisture-resistant ring 7 can be arranged so as to entirely circumferentially surround the light emitting element array 3 and the pads 8. The second moisture-resistant ring 11 can be arranged to entirely circumferentially surround the structure arranged inside the second moisture-resistant ring 11.

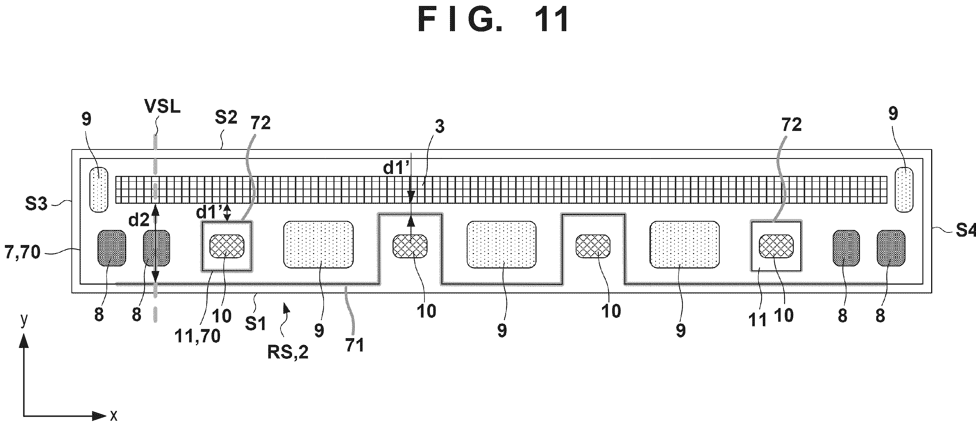

A light emitting apparatus 2 according to the third embodiment will be described below with reference to Fig. 11. Fig. 11 schematically shows the arrangement of one light emitting apparatus 2 according to the third embodiment. Note that matters that are not referred to in the third embodiment can comply with the first and second embodiments unless any contradiction occurs.

The light emitting apparatus 2 can include a moisture-resistant ring structure 70 that is arranged in a rectangular substrate RS so as to suppress the infiltration of moisture into a light emitting element array 3 and all pads 8. The moisture-resistant ring structure 70 can include moisture-resistant walls 71 and 72 arranged between the light emitting element array 3 and a first side S1. Referring to Fig. 11, the moisture-resistant walls 71 and 72 of the moisture-resistant ring structure 70 are indicated by the thick gray lines. The shortest distance between the light emitting element array 3 and the moisture-resistant walls 71 and 72 in the Y direction (second direction) is a distance d1'. In the case shown in Fig. 11, both the shortest distance between the light emitting element array 3 and the moisture-resistant wall 71 in the Y direction (second direction) and the shortest distance between the light emitting element array 3 and the moisture-resistant wall 72 in the Y direction (second direction) are the distance d1'. However, at least one of the shortest distance between the light emitting element array 3 and the moisture-resistant wall 71 in the Y direction (second direction) and the shortest distance between the light emitting element array 3 and the moisture-resistant wall 72 in the Y direction (second direction) may be the distance d1'. The distance between the light emitting element array 3 and the moisture-resistant wall 71 on a virtual straight line VSL parallel to the Y direction (second direction) and passing through the light emitting element array 3 and the pad 8 is a distance d2. In the third embodiment, the distance d1' is smaller than the distance d2. This reduces the distance (interval) between the adjacent light emitting apparatuses 2 on a material substrate 1 in the Y direction and increases the number of light emitting apparatuses 2 that can be formed on the material substrate 1, and hence is advantageous in reducing the manufacturing cost of the light emitting apparatuses 2.

The moisture-resistant ring structure 70 can include a first moisture-resistant ring 7 arranged so as to surround the light emitting element array 3 and the pads 8 and a second moisture-resistant ring 11 arranged so as not to surround the light emitting element array 3 and the pads 8 and so as to be surrounded by the first moisture-resistant ring 7. The first moisture-resistant ring 7 can include a portion that defines the distance d2 between the light emitting element array 3 and the moisture-resistant walls 71 and 72 on the virtual straight line VSL. At least one of the first moisture-resistant ring 7 and the second moisture-resistant ring 11 can include a portion that defines the shortest distance d1' between the light emitting element array 3 and the moisture-resistant walls 71 and 72. The first moisture-resistant ring 7 can be arranged so as to entirely circumferentially surround the light emitting element array 3 and the pads 8. The second moisture-resistant ring 11 can be arranged to entirely circumferentially surround the structure arranged inside the second moisture-resistant ring 11.

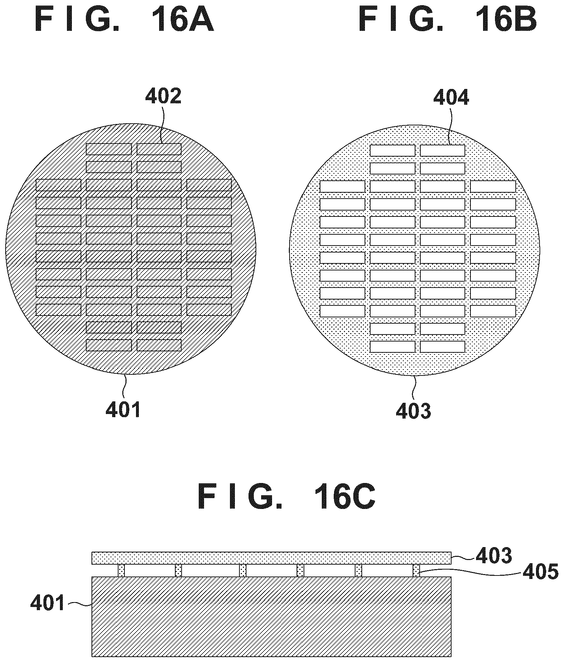

A light emitting apparatus 402 according to the fourth embodiment will be described below with reference to Figs. 16 to 21. Note that matters that are not referred to in the fourth embodiment can comply with at least one of the first to third embodiments unless any contradiction occurs. Numerical values, shapes, materials, constituent elements, placement and connection forms of constituent elements, and the like are not intended to limit the disclosure range unless explicitly specified otherwise.

An OLED will be exemplarily described as a light emitting element. Note that the present disclosure is not limited to the OLED and can be applied to current-driven type light emitting apparatuses in general.

Fig. 16A shows a case where the light emitting apparatus 402 according to the fourth embodiment is formed on a material substrate 401 such as a silicon wafer. The light emitting apparatuses 402 can be formed in a matrix pattern on the substrate 401. In the case of the rectangular light emitting apparatuses 402, since the yield on one material substrate 401 greatly changes depending on the size in the short side direction, minimizing the size in the short side direction is effective in reducing the cost. If a silicon wafer is used as a substrate for the manufacture of the light emitting apparatus 402, a driving circuit can be micro-fabricated. This can increase the density of OLEDs. Increasing the density can form images with higher resolution.

Fig. 16B shows an example of a deposition mask 403 for forming OLEDs on the light emitting apparatuses 402. A plurality of openings 404 are arranged in the deposition mask 403. The arrangement intervals of the plurality of openings 404 are equal to those of the plurality of light emitting apparatuses 402. After the light emitting apparatuses 402 on the material substrate 401 are stacked on the openings 404 of the deposition mask 403 in planar view, the material substrate 401 is brought into close contact with ribs 405 of the deposition mask 403, and electrodes and organic layers are deposited on light emitting apparatuses by a vacuum deposition method, thereby forming OLEDs.

Fig. 16C shows an example of a sectional structure when the material substrate 401 is brought into close contact with the ribs 405 of the deposition mask 403. When the material substrate 401 is brought into close contact with the ribs 405 of the deposition mask 403, the ribs 405 of the deposition mask 403 make it possible to maintain the interval constant between the material substrate 401 and the pattern portions (portions other than the ribs 405) of the deposition mask 403. In addition, the ribs 405 can minimize the area of the deposition mask 403 which comes into contact with the light emitting apparatuses 402 and prevent the transfer of foreign substances to the light emitting apparatuses 402 and the occurrence of flaws, thus preventing the occurrence of sealing failures.

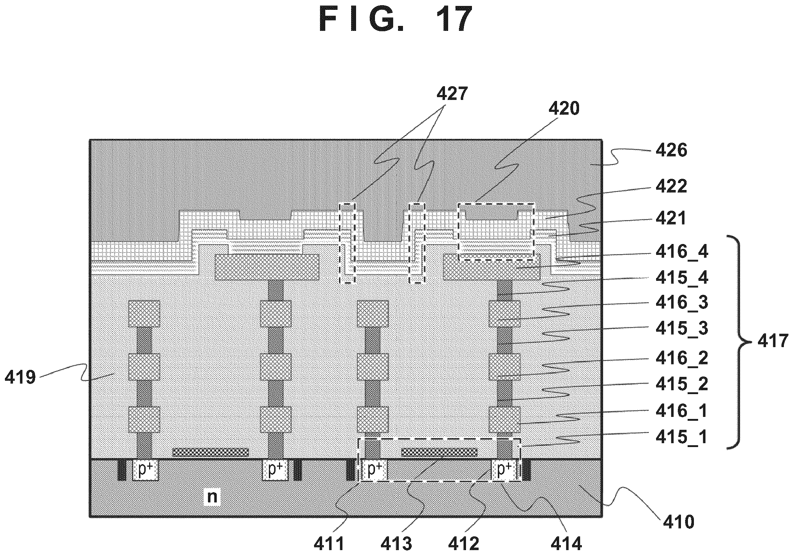

Fig. 17 is a sectional schematic view showing an example of an OLED 420 and a transistor 414 connected to the OLED 420. The transistor is an example of a functional element. The transistor may be a thin film transistor (TFT). Fig. 17 shows the OLED 420 and the transistor 414. A drain 412 and a source 411 of the transistor 414 are arranged in a silicon substrate 410. A gate 413 of the transistor 414 is arranged on the silicon substrate 410 through a gate insulating film (not shown).

A wiring 417 is composed of a plurality of contact plugs 415_1 to 415_4 and a plurality of metal wirings 416_1 to 416_4 which electrically connect the drain 412 of the transistor 414 to the OLED 420. An insulating layer 419 is provided between the wirings. Although Fig. 17 shows the insulating layer 419 as if it were a single layer, the insulating layer 419 may have a multilayer structure composed of a plurality of layers.

The OLED 420 can be composed of the first electrode 416-4, an organic film 421 having a light emitting layer, and a second electrode 422. Although Fig. 17 shows the organic film 421 as if it were a single layer, the organic film 421 may be composed of a plurality of layers. In the OLED 420, the second electrode 422 is a transparent electrode, and light from the organic film 421 is extracted to the outside through the second electrode 422. A protective layer 425 is provided on the second electrode 422 to reduce a deterioration in the OLED 420. The second electrode 422 of the OLED 420 is shared by the plurality of OLEDs 420 and serves as a common electrode.

In the light emitting apparatus 402, constituent units composed of combinations of the OLEDs 420 and the transistors 414 are repeatedly arranged in the row and column directions. A structure 427 having a large stepped portion can be formed on a layer immediately below the organic film 421 between the respective OLEDs 420. With the structure 427, the second electrode 422 may be formed to provide electrical connection while the organic film 421 is electrically isolated. A scheme of electrically connecting the OLED 420 to the electrodes (source and drain electrodes) included in the transistor 414 is not limited to the mode shown in Fig. 17. It is at least required to electrically connect one of the source and drain electrodes of the transistor 414 to the first electrode 416_4 of the OLED 420 in accordance with the polarity of the OLED 420 and the first electrode 416_4 and the polarity of the transistor 414. Referring to Fig. 17, although a transistor is used as a switching element, another switching element may be used instead of the transistor.

In addition, the transistor is not limited to the transistor formed on a single crystal silicon wafer and may be a thin film transistor having an active layer on the insulating surface of a substrate. Examples of the active layer are single crystal silicon, non-single crystal silicon such as amorphous silicon and microcrystal silicon, and non-single crystal oxide semiconductors such as indium zinc oxide and indium gallium zinc oxide.

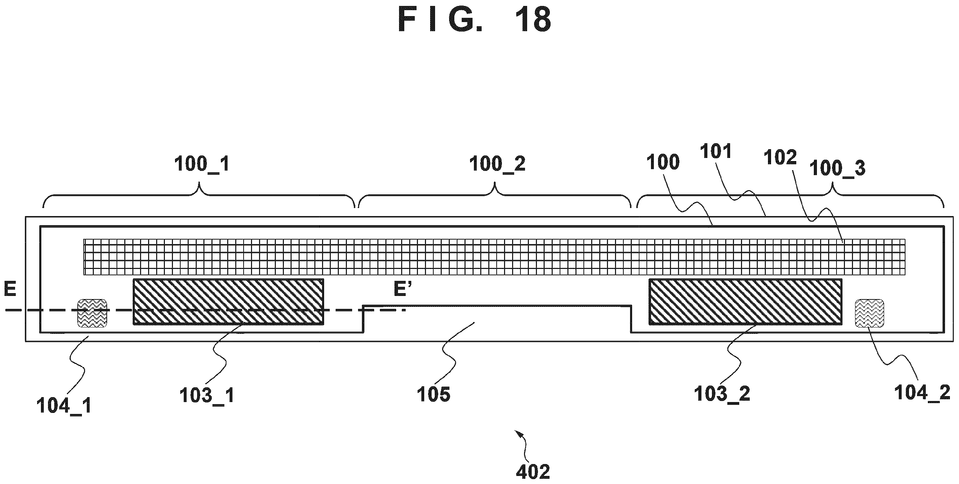

Fig. 18 is a schematic view showing one form of the light emitting apparatus 402 according to the fourth embodiment. The light emitting apparatus 402 according to the fourth embodiment has a rectangular shape having long sides parallel to the first direction and short sides parallel to a direction intersecting the first direction.

In the light emitting apparatus 402, when a light emitting region 102 is formed along the long side direction, members other than the light emitting region 102, such as a contact region can be arranged in a region adjacent to the light emitting region 102 in the short side direction out of the peripheral region of the light emitting region 102.

A substrate 101 has a rectangular shape. In this specification, the long side direction of the rectangular substrate 101 is called the first direction, and the short side direction orthogonal to the long side direction is called the second direction. A moisture-resistant ring 100 that functions to prevent the infiltration of moisture into the light emitting apparatus 402 is arranged on the rectangular substrate 101. In addition, the light emitting region 102, a first contact region 103_1, a second contact region 103_2, and pads 104_1 and 104_2 are arranged in the region surrounded by the moisture-resistant ring 100. A plurality of light emitting elements are arranged in the light emitting region 102 in the matrix directions. The first contact region 103_1 and the second contact region 103_2 are regions in which wirings electrically connected to the common electrode of the OLED are arranged. The pads 104_1 and 104_2 are electrically connected to a contact region.

In the light emitting region 102, a plurality of light emitting elements are arranged in a matrix pattern. As described above, each light emitting element includes the light emitting layer and the first and second electrodes sandwiching the light emitting layer. The first electrode is an independent electrode provided for each light emitting element, and the second electrode is a common electrode provided common to the respective light emitting elements.

The first contact region 103_1 and the second contact region 103_2 are adjacent regions of the light emitting region 102 of the substrate 101 and are provided in regions surrounded by the moisture-resistant ring 100. A concave portion 105, the first contact region 103_1, the second contact region 103_2, and the pads 104_1 and 104_2 are arranged between the light emitting region 102 and one long side end portion of the substrate 101. In other words, the concave portion 105, the first contact region 103_1, the second contact region 103_2, and the pads 104_1 and 104_2 can be arranged in one short side direction when viewed from the light emitting region 102. The concave portion 105 can be arranged between the first contact region 103_1 and the second contact region 103_2. The concave portion 105, the first contact region 103_1, the second contact region 103_2, and the pads 104_1 and 104_2 are arranged in series along the long side direction. In the case shown in Fig. 18, the pad 104_1, the first contact region 103_1, the concave portion 105, the second contact region 103_2, and the pad 104_2 are sequentially arranged in series along the long side direction in this order.

The moisture-resistant ring 100 is a guard ring formed of a wiring layer and is provided so as to surround the light emitting region 102, the first contact region 103_1, the second contact region 103_2, and the pads 104_1 and 104_2. The moisture-resistant ring 100 can have one or more concave portions 105 in one of the long sides of the substrate. The moisture-resistant ring 100 can have a narrow portion 100_2 and wide portions 100_1 and 100_3 respectively provided on the two sides of the narrow portion 100_2 in the long side direction (first direction). The width of the narrow portion 100_2 in the short side direction (second direction) may be shorter than the width of the wide portions 100_1 and 100_3 in the short side direction. The width of the wide portions 100_1 and 100_3 in the short side direction may be longer than the width of the narrow portion 100_2 in the short side direction. The position of one of the long sides of the narrow portion 100_2 in the short side direction may coincide with that of each of the wide portions 100_1 and 100_3, whereas the positions of the other long sides of them in the short side direction may differ from each other. Owing to the presence of the narrow portion 100_2, the moisture-resistant ring 100 has a concave portion in the outer circumference. In this embodiment, this portion is called the concave portion 105. The concave portion 105 may be used as an abutment region against which the ribs 405 as part of the deposition mask 403 are made to abut in a deposition process. The width of the narrow portion 100_2 in the short side direction may be shorter than the wide portions 100_1 and 100_3 by an amount corresponding to the width of the concave portion 105 in the short side direction. The first contact region 103_1 and the second contact region 103_2 are respectively arranged inside the wide portions 100_1 and 100_3 of the moisture-resistant ring 100.

A driving circuit for the light emitting apparatus 402 can be formed inside the moisture-resistant ring 100 (not shown). In forming an OLED, the ribs 405 of the deposition mask 403 comes into contact with the concave portion 105 of the moisture-resistant ring 100, in other words, the outside of the moisture-resistant ring 100 at the narrow portion 100_2 to maintain the distance constant between the deposition mask 403 and the pattern portion. The ribs 405 functions to minimize the area where the deposition mask 403 comes into contact with the light emitting apparatus 402, prevent the transfer of foreign substances to the light emitting apparatuses 402 and the occurrence of flaws, and prevent the occurrence of sealing failures. If the ribs 405 come into contact with the substrate, flaws may occur in the insulating film on the substrate and reduce the sealing performance of the light emitting apparatus 402. In this embodiment, the sealing performance of the light emitting apparatus 402 is guaranteed by arranging the concave portion 105 serving as the abutment region of the ribs 405 outside the moisture-resistant ring.

The second electrode (upper electrode/common electrode) 422 of each OLED according to this embodiment is formed of a transparent electrode material and hence has a relatively high wiring resistance. In addition, since the second electrode 422 is a common electrode, currents flow from a plurality of OLEDs into the electrode, resulting in a large voltage drop at the second electrode 422. This may cause differences in voltage applied to the respective OLEDs depending on the distances from the contact regions to which potentials are supplied. This sometimes causes differences in actual emission luminance between OLEDs to which voltages for emission with the same luminance level are applied, resulting in shading and the like.

The light emitting apparatus 402 according to this embodiment can have at least two contact regions (the contact regions 103_1 and 103_2) to the second electrode (upper electrode/common electrode) 422 and the power supply wiring along a long side end of the light emitting apparatus 402. Bringing the second electrode 422 into contact with the power supply wiring with low resistance at a plurality of positions in the long side direction can reduce the voltage drop at the second electrode 422. For this reason, even if a plurality of OLEDs have the common second electrode 422, it is possible to suppress a voltage drop dependent on the position of the second electrode 422 and suppress shading of emission luminance.

The first contact region 103_1 or the second contact region 103_2 and abutment region of the ribs 405 of the deposition mask 403 may be arranged in series along the short side direction of the light emitting apparatus 402. In this case, however, a region dedicated to ribs is provided between the light emitting apparatuses 402 in the short side direction, and hence the size of the light emitting apparatus 402 increases by an amount corresponding to the rib dedicated region. The light emitting apparatus 402 according to this embodiment has the concave portion 105 of the moisture-resistant ring as a rib abutment region arranged between the first contact region 103_1 and the second contact region 103_2. This can reduce the distance between the light emitting apparatuses 402 in the short side direction. Accordingly, it is possible to increase the number of light emitting apparatuses 402 within one substrate in the short side direction and the yield.

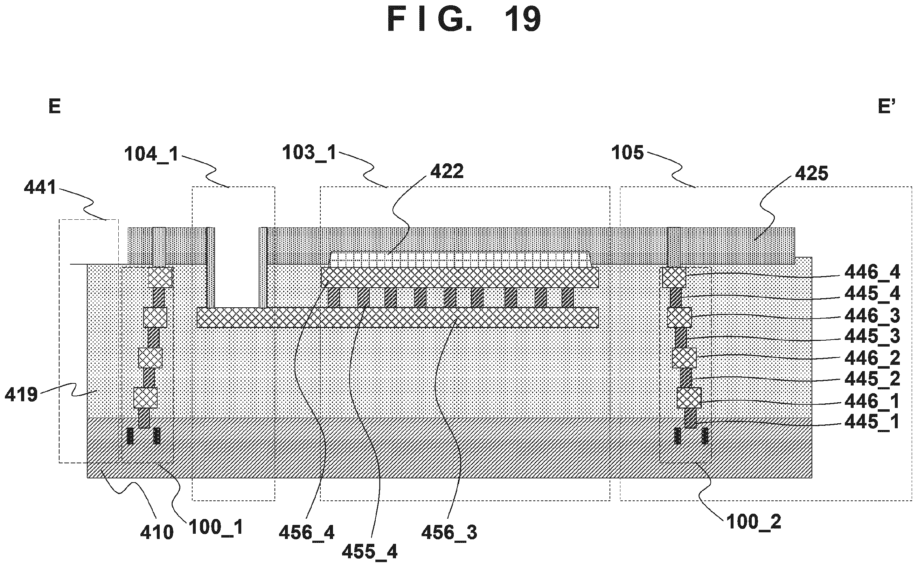

Fig. 19 is a sectional view taken along line E - E' in the light emitting apparatus 402 in Fig. 18. A moisture-resistant ring 100_2 has a multilayer structure formed by stacking contact plugs 445_1 to 445_4 and metal wirings 446_1 to 446_4 and extends from the surface of the light emitting apparatus 402 to a depth reaching the silicon substrate 410 in which circuit elements are formed. The contact plugs 445_1 to 445_4 and the metal wirings 446_1 to 446_4 forming the moisture-resistant ring 100_2 are formed of the same layer as that of contact plugs 415_1 to 415_4 and metal wirings 416_1 to 416_4 forming the wiring 417. As described above, the moisture-resistant ring 100_2 has the same layer structure as the multilayer wiring structure of the internal circuit and can be formed simultaneously with the internal circuit in a common process.

The sectional structure of the moisture-resistant ring 100_1 can have the same structure as that of the moisture-resistant ring 100_2 at any positions in the light emitting apparatus 402.

The moisture-resistant rings 100_1 and 100_2 are in physical contact with the protective layer 425 of the OLED 420 and function to prevent the infiltration of moisture into the OLED 420.

In a scribe region 441, the protective layer 425 of the light emitting apparatus 402 is omitted. This makes it possible to prevent crack in the protective layer 425 when cutting the light emitting apparatus 402 from the silicon substrate 410.

In the contact region 103_1, the second electrode (common electrode) 422 of the OLED 420 is in physical contact with a metal wiring 456_4. The pad 104_1 is formed of the metal wiring of the same layer as that of a metal wiring 456_3. In this structure, the metal wiring 456_3 with low resistance extends from the pad 104_1 to immediately below the contact region 103_1, and a contact plug 455_4 provides electrical continuity with low resistance between the metal wiring 456_3 and the metal wiring 456_4. In this embodiment, the pad 104_1 is the same layer as that of the metal wiring 456_3. However, for example, the pad 104_1 may be a wiring of the same layer as that of the metal wiring 456_4.

Adopting the arrangement described in this embodiment can obtain the effect of improving the yield and manufacturing the light emitting apparatuses 402 at low cost while suppressing shading of luminance in the light emitting apparatuses 402.

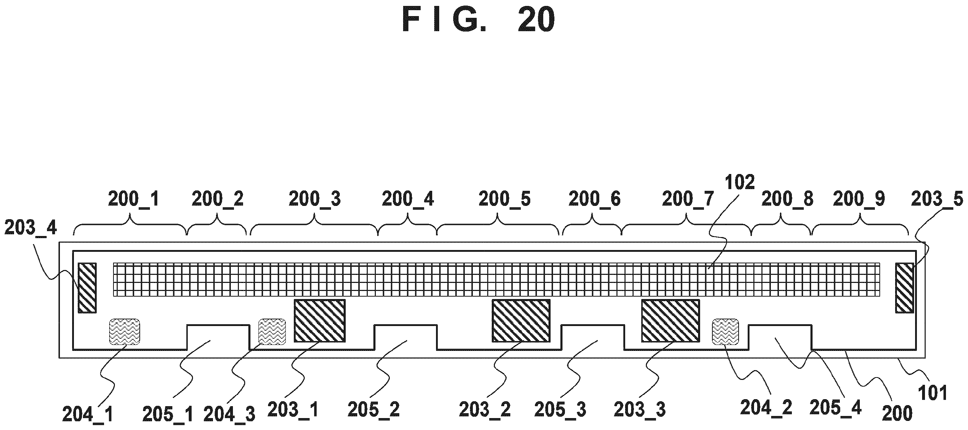

A light emitting apparatus 402 according to the fifth embodiment will be described below with reference to Fig. 20. Note that matters that are not referred to in the fifth embodiment can comply with the fourth embodiment unless any contradiction occurs. Fig. 20 is a schematic view showing the arrangement of a light emitting apparatus according to the fifth embodiment.

A moisture-resistant ring 200, light emitting regions 102 in which light emitting pixels arranged in the matrix directions are arranged, contact regions 203_1 to 203_5 electrically connected to the common electrode of the OLED, and pads 204_1 to 204_3 electrically connected to the contact regions are arranged on a rectangular substrate 101.

In this embodiment, the moisture-resistant ring 200 is formed by alternately arranging five wide portions 200_1, 200_3, 200_5, 200_7, and 200_9 and four narrow portions 200_2, 200_4, 200_6, and 200_8. The width of the narrow portions 200_2, 200_4, 200_6, and 200_8 in the short side direction is shorter than the width of the wide portions 200_1, 200_3, 200_5, 200_7, and 200_9 in the short side direction. The following is an example in which the four narrow portions are formed. However, the number of narrow portions is not limited to this number.

Owing to the presence of the wide portions 200_1, 200_3, 200_5, 200_7, and 200_9, the outer circumferential shape of the moisture-resistant ring 200 includes a plurality of concave portions. These portions are called concave portions 205_1 to 205_4 of the moisture-resistant ring. The concave portions 205_1 to 205_4 may be used as abutment regions against which ribs as part of a deposition mask are made to abut in a deposition process. In this embodiment, the concave portions 205_1 to 205_4 of the moisture-resistant ring 200 are arranged along the long sides of the light emitting apparatus. This arrangement makes it possible to reduce the arrangement intervals of the rib abutment regions on the substrate 101 and suppress the flexure of the deposition mask. In addition, reducing the arrangement intervals of the rib abutment regions can shorten the length of each concave portion as the abutment region in the long side direction and reduce the interval between the first contact region and the second contact region. Accordingly, it is possible to further reduce the resistance of a common electrode at a middle portion of the light emitting apparatus and suppress luminance shading in the light emitting apparatus. Alternately arranging the common electrode, the contact regions 203_1 to 203_3 of the power supply wiring, and the concave portions 205_1 to 205_3 of the moisture-resistant ring can reduce the resistance of the common electrode at a plurality of positions.

The light emitting apparatus can be further miniaturized by arranging members other than the light emitting regions such as contact regions of the light emitting apparatus in the long side direction. This makes it possible to increase the yield on the substrate and reduce the cost. That members A and B are arranged in series in the first direction in this specification indicates that there is a portion where members A and B are stacked on each other in planar view from the first direction with respect to a plane perpendicular to the first direction.

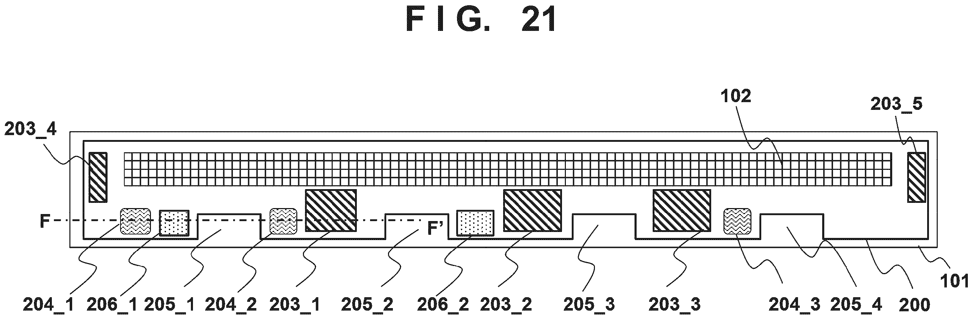

A light emitting apparatus 402 according to the sixth embodiment will be described below with reference to Fig. 21. Note that matters that are not referred to in the sixth embodiment can comply with the fifth embodiment unless any contradiction occurs. Fig. 21 is a schematic view showing the arrangement of a light emitting apparatus according to the sixth embodiment. In comparison with the light emitting apparatus in Fig. 20, circuits 206_1 and 206_2 for respectively driving the light emitting elements are added. The circuits 206_1 and 206_2 are arranged in series in the long side direction. In other words, the circuits 206_1 and 206_2 are additionally arranged so as to be stacked each other in planar view with respect to a plane perpendicular to the long side direction. In addition, the circuits 206_1 and 206_2 are arranged in series in the long side direction together with contact regions 203_1 to 203_3 and pads 204_1 to 204_3.

Specific examples of the circuits 206_1 and 206_2 are input protection circuits, input circuits to which each driving data is input, and logic circuits for processing data. However, limitation is not made thereto. The length of the light emitting apparatus in the short side direction can be reduced by providing circuit regions at the same positions as those of the contact regions and the pad regions in the short side direction and arranging circuits in the circuit regions.

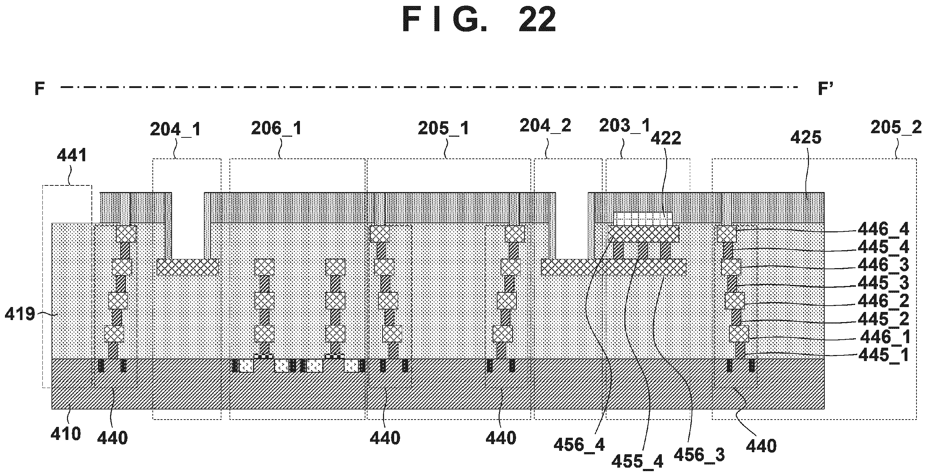

Fig. 22 is a sectional view taken along line F - F' in the light emitting apparatus in Fig. 21. This structure is obtained by adding the circuits 206_1 and 206_2 to the structure in Fig. 19.

Adopting the arrangement described in this embodiment can effectively suppress shading of luminance in the light emitting apparatus.

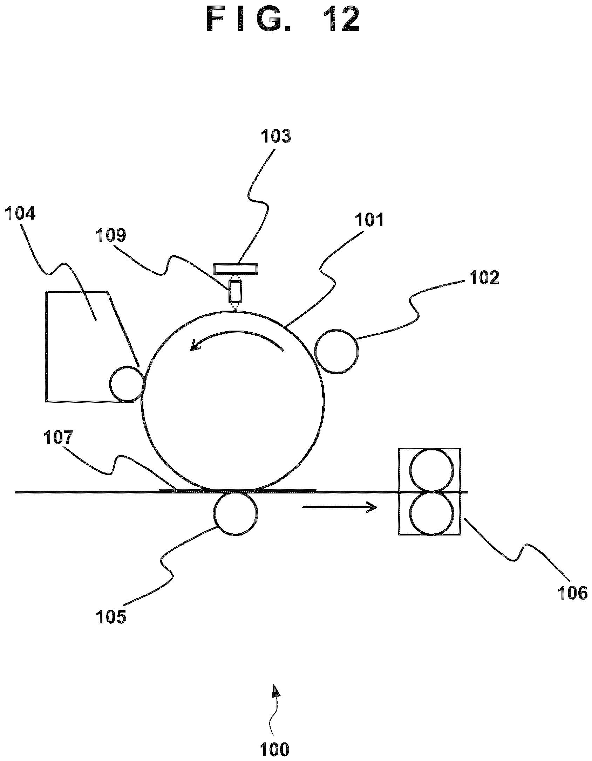

An image forming apparatus 100 incorporating a light emitting apparatus 2 represented by the first to third embodiments will be exemplarily described with reference to Fig. 12. Fig. 12 schematically shows the arrangement of the image forming apparatus 100. The image forming apparatus 100 can be configured as an electrophotographic image forming apparatus. The image forming apparatus 100 can include a photoconductive body 101, a charging unit 102 that charges the photoconductive body 101, an exposure unit 103 that exposes the surface of the photoconductive body 101 to light so as to form an electrostatic latent image on the surface, and a developing unit 104 that develops the electrostatic latent image. The exposure unit 103 can include the light emitting apparatus 2 described above as a light source. The developing unit 104 can form an image by attaching toner to an electrostatic latent image. The image forming apparatus 100 may further include a transfer unit 105 that transfers the image forming by the developing unit 104 onto a recording medium 107 and a fixing unit 108 that fixes the image transferred onto the recording medium 107.

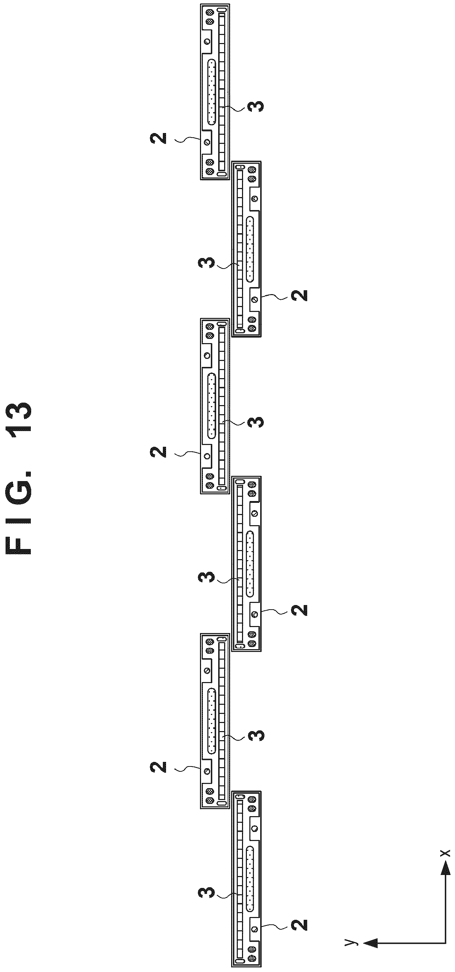

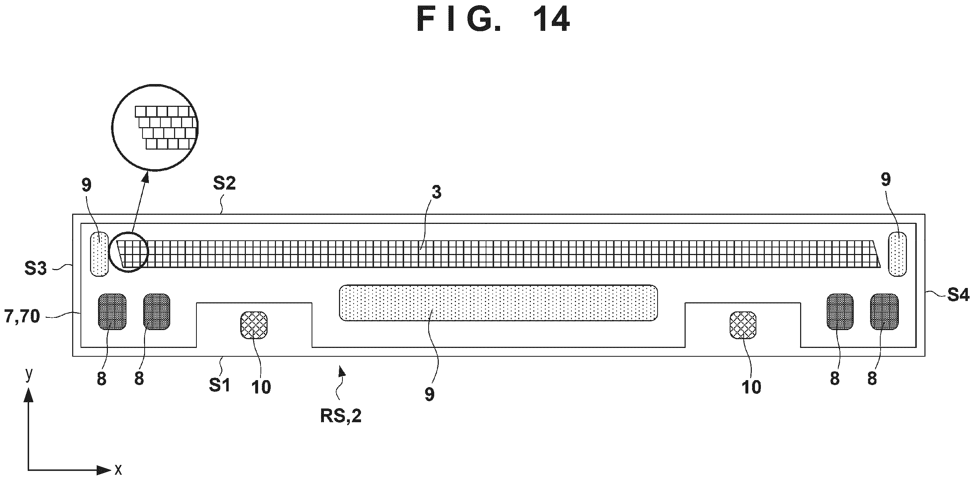

Referring to Fig. 12, the X direction is expressed as columns (the arraying direction thereof), and the Y direction is expressed as rows (the arraying direction thereof). In this case, the X direction may be a direction along the rotational axis direction of the photoconductive body 101 of the image forming apparatus 100. A plurality of light emitting apparatuses 2 can be arrayed to form a light source for the exposure unit 103. For example, the plurality of light emitting apparatuses 2 can be arranged in a staggered arrangement, as exemplarily shown in Fig. 13. The light emitting elements in each light emitting element array 3 may be arranged in one row or may be arranged to form a plurality of rows. The arrangement in which the light emitting elements are arranged to form a plurality of rows in each light emitting element array 3 is advantageous in tone expression and is also advantageous in reducing the light emission amount of each light emitting element and increasing the service life of the light emitting element. Assume that the light emitting elements are arranged to form a plurality of rows in each light emitting element array 3. In this case, as exemplarily shown in Fig. 14, if there are four rows of light emitting elements, the position of the first light emitting element in the first row and the position of the first light emitting element in the second row may be shifted from each other in the X direction by 1/4 of the dimension of the light emitting element in the X direction. In the case of n rows, the position of the first light emitting element in the first row and the position of the first light emitting element in the second row may be shifted from each other in the X direction by 1/n of the dimension of the light emitting element in the X direction. This arrangement is advantageous in improving the resolution.

The details of each constituent element of the light emitting apparatus 2 will be exemplarily described below.

### [Arrangement of Organic Light Emitting Element]

The organic light emitting element is provided by forming an insulating layer, a first electrode, an organic film, and a second electrode on a substrate. A protection layer, a color filter, a microlens, and the like may be provided on a cathode. If a color filter is provided, a planarizing layer can be provided between the protection layer and the color filter. The planarizing layer can be made of acrylic resin or the like. The same applies to a case in which a planarizing layer is provided between the color filter and the microlens.

### [Substrate]

Quartz, glass, a silicon wafer, a resin, a metal, or the like may be used as a substrate. Furthermore, a switching element such as a transistor and a wiring may be provided on the substrate, and an insulating layer may be provided thereon. The insulating layer may be made of any material as long as a contact hole can be formed so that the wiring can be formed between the insulating layer and the first electrode and insulation from the unconnected wiring can be ensured. For example, a resin such as polyimide, silicon oxide, silicon nitride, or the like can be used.

### [Electrode]

A pair of electrodes can be used as the electrodes. The pair of electrodes can be an anode and a cathode. If an electric field is applied in the direction in which the organic light emitting element emits light, the electrode having a high potential is the anode, and the other is the cathode. It can also be said that the electrode that supplies holes to the light emitting layer is the anode and the electrode that supplies electrons is the cathode.

As the constituent material of the anode, a material having a work function as large as possible is preferably used. For example, a metal such as gold, platinum, silver, copper, nickel, palladium, cobalt, selenium, vanadium, or tungsten can be used. Alternatively, a mixture containing some of them, an alloy obtained by combining some of them, or a metal oxide such as tin oxide, zinc oxide, indium oxide, indium tin oxide (ITO), or zinc indium oxide can be used. Furthermore, a conductive polymer such as polyaniline, polypyrrole, or polythiophene can also be used.

One of these electrode materials may be used singly, or two or more of them may be used in combination. The anode may be formed by a single layer or a plurality of layers.

If the anode is used as a reflective electrode, for example, chromium, aluminum, silver, titanium, tungsten, molybdenum, an alloy thereof, a stacked layer thereof, or the like can be used. The above materials can function as a reflective film having no role as an electrode. If the anode is used as a transparent electrode, an oxide transparent conductive layer made of indium tin oxide (ITO), indium zinc oxide, or the like can be used, but the present invention is not limited thereto. A photolithography technique can be used to form the electrode.

On the other hand, as the constituent material of the cathode, a material having a small work function is preferably used. Examples of the material include an alkali metal such as lithium, an alkaline earth metal such as calcium, a metal such as aluminum, titanium, manganese, silver, lead, or chromium, and a mixture containing some of them. Alternatively, an alloy obtained by combining these metals can also be used. For example, a magnesium-silver alloy, an aluminum-lithium alloy, an aluminum-magnesium alloy, a silver-copper alloy, a zinc-silver alloy, or the like can be used. A metal oxide such as indium tin oxide (ITO) can also be used. One of these electrode materials may be used singly, or two or more of them may be used in combination. The cathode may have a single-layer structure or a multilayer structure. Among others, silver is preferably used. To suppress aggregation of silver, a silver alloy is more preferably used. The ratio of the alloy is not limited as long as aggregation of silver can be suppressed. For example, the ratio between silver and another metal may be 1 : 1, 3 : 1, or the like.

The cathode may be a top emission element using an oxide conductive layer made of ITO or the like, or may be a bottom emission element using a reflective electrode made of aluminum (Al) or the like, and is not particularly limited. The method of forming the cathode is not particularly limited, but direct current sputtering or alternating current sputtering is preferably used since the good film coverage is provided and the resistance is easily lowered.

### [Pixel Isolation Layer]

A pixel isolation layer is formed by a silicon nitride (SiN) film, a silicon oxynitride (SiON) film, or a silicon oxide (SiO) film formed using a Chemical Vapor Deposition method (CVD method). To increase the resistance in the in-plane direction of the organic film, the organic film, especially the hole transport layer is preferably thinly deposited on the side wall of the pixel isolation layer. More specifically, the organic compound layer can be deposited so as to have a thin film thickness on the side wall by increasing the taper angle of the side wall of the pixel isolation layer or the film thickness of the pixel isolation layer to increase vignetting during vapor deposition.

On the other hand, it is preferable to adjust the taper angle of the side wall of the pixel isolation layer or the film thickness of the pixel isolation layer to the extent that no space is formed in the protection layer formed on the pixel isolation layer. Since no space is formed in the protection layer, it is possible to reduce generation of defects in the protection layer. Since generation of detects in the protection layer is reduced, a decrease in reliability caused by generation of a dark spot or occurrence of a conductive failure of the second electrode can be reduced.

According to this embodiment, even if the taper angle of the side wall of the pixel isolation layer is not acute, it is possible to effectively suppress leakage of charges to an adjacent pixel. As a result of this consideration, it has been found that the taper angle of 60° (inclusive) to 90° (inclusive) can sufficiently reduce the occurrence of defects. The film thickness of the pixel isolation layer is desirably 10 nm (inclusive) to 150 nm (inclusive). A similar effect can be obtained in an arrangement including only pixel electrodes without the pixel isolation layer. However, in this case, the film thickness of the pixel electrode is preferably set to be equal to or smaller than half the film thickness of the organic layer or the end portion of the pixel electrode is preferably formed to have a forward tapered shape of less than 60° because short circuit of the organic light emitting element can be reduced.

### [Organic Film]

The organic film may be formed by a single layer or a plurality of layers. If the organic film includes a plurality of layers, the layers can be called a hole injection layer, a hole transport layer, an electron blocking layer, a light emitting layer, a hole blocking layer, an electron transport layer, and an electron injection layer in accordance with the functions of the layers. The organic film is mainly formed from an organic compound but may contain inorganic atoms and an inorganic compound. For example, the organic film may contain copper, lithium, magnesium, aluminum, iridium, platinum, molybdenum, zinc, or the like. The organic film may be arranged between the first and second electrodes, and may be arranged in contact with the first and second electrodes.

If the organic film has a plurality of light emitting layers, the film may has a charge generating unit between the first light emitting layer and the second light emitting layer. The charge generating unit may have an organic compound with a lowest unoccupied molecular orbital energy (LUMO) of 5.0 eV or less. The same applies to a case where the organic film has a charge generating unit between the second light emitting layer and the third light emitting layer.

### [Protection Layer]

A protection layer may be provided on the second electrode. For example, by adhering glass provided with a moisture absorbing agent on the second electrode, permeation of water or the like into the organic film can be suppressed and occurrence of display defects can be suppressed. Furthermore, as another embodiment, a passivation film made of silicon nitride or the like may be provided on the cathode to suppress permeation of water or the like into the organic film. For example, the protection layer can be formed by forming the cathode, transferring it to another chamber without breaking the vacuum, and forming a silicon nitride film having a thickness of 2 µm by the CVD method. The protection layer may be provided using an atomic deposition method (ALD method) after deposition using the CVD method. The material of the film by the ALD method is not limited but can be silicon nitride, silicon oxide, aluminum oxide, or the like. A silicon nitride film may further be formed by the CVD method on the film formed by the ALD method. The film formed by the ALD method may have a film thickness smaller than that of the film formed by the CVD method. More specifically, the film thickness of the film formed by the ALD method may be 50% or less, or 10% or less.

### [Color Filter]

A color filter may be provided on the protection layer. For example, a color filter considering the size of the organic light emitting element may be provided on another substrate, and this substrate may be bonded to the substrate with the organic light emitting element provided thereon. Alternatively, a color filter may be patterned on the above-described protection layer using a photolithography technique. The color filter can be formed from a polymeric material.

### [Planarizing Layer]

A planarizing layer may be provided between the color filter and the protection layer. The planarizing layer is provided to reduce unevenness of the lower layer. The planarizing layer may be called a material resin layer without limiting the purpose of the layer. The planarizing layer can be formed from an organic compound, and can be made of a low-molecular material or a polymeric material. However, a polymetric material is more preferable.

The planarizing layers may be provided above and below the color filter, and the same or different materials may be used for them. More specifically, examples of the material include polyvinyl carbazole resin, polycarbonate resin, polyester resin, ABS resin, acrylic resin, polyimide resin, phenol resin, epoxy resin, silicone resin, and urea resin.

### [Microlens]

The organic light emitting apparatus can include an optical member such as a microlens on the light emission side. The microlens can be made of acrylic resin, epoxy resin, or the like. The microlens can aim to increase the amount of light extracted from the organic light emitting apparatus and control the direction of light to be extracted. The microlens can have a hemispherical shape. If the microlens has a hemispherical shape, among tangents contacting the hemisphere, there is a tangent parallel to the insulating layer, and the contact between the tangent and the hemisphere is the vertex of the microlens. The vertex of the microlens can be decided in the same manner even in an arbitrary sectional view. That is, among tangents contacting the semicircle of the microlens in a sectional view, there is a tangent parallel to the insulating layer, and the contact between the tangent and the semicircle is the vertex of the microlens.

Furthermore, the middle point of the microlens can also be defined. In the section of the microlens, a line segment from a point at which an arc shape ends to a point at which another arc shape ends is assumed, and the middle point of the line segment can be called the middle point of the microlens. A section for determining the vertex and the middle point may be a section perpendicular to the insulating layer.

The microlens includes a first surface including a convex portion and a second surface opposite to the first surface. The second surface is preferably arranged on the functional layer side of the first surface. For this arrangement, the microlens needs to be formed on the light emitting apparatus. If the functional layer is an organic layer, it is preferable to avoid a process which produces high temperature in the manufacturing step. In addition, if it is configured to arrange the second surface on the functional layer side of the first surface, all the glass transition temperatures of an organic compound forming the organic layer are preferably 100°C or more, and more preferably 130°C or more.

### [Counter Substrate]

A counter substrate can be provided on the planarizing layer. The counter substrate is called a counter substrate because it is provided at a position corresponding to the above-described substrate. The constituent material of the counter substrate can be the same as that of the above-described substrate. If the above-described substrate is the first substrate, the counter substrate can be the second substrate.

### [Organic Layer]

The organic film (hole injection layer, hole transport layer, electron blocking layer, light emitting layer, hole blocking layer, electron transport layer, electron injection layer, and the like) forming the organic light emitting element according to an embodiment of the present invention is formed by the method to be described below.

The organic film forming the organic light emitting element according to the embodiment of the present invention can be formed by a dry process using a vacuum deposition method, an ionization deposition method, a sputtering method, a plasma method, or the like. Instead of the dry process, a wet process that forms a layer by dissolving a solute in an appropriate solvent and using a well-known coating method (for example, a spin coating method, a dipping method, a casting method, an LB method, an inkjet method, or the like) can be used.

Here, when the layer is formed by a vacuum deposition method, a solution coating method, or the like, crystallization or the like hardly occurs and excellent temporal stability is obtained. Furthermore, when the layer is formed using a coating method, it is possible to form the film in combination with a suitable binder resin.

Examples of the binder resin include polyvinyl carbazole resin, polycarbonate resin, polyester resin, ABS resin, acrylic resin, polyimide resin, phenol resin, epoxy resin, silicone resin, and urea resin. However, the binder resin is not limited to them.

One of these binder resins may be used singly as a homopolymer or a copolymer, or two or more of them may be used in combination. Furthermore, additives such as a well-known plasticizer, antioxidant, and an ultraviolet absorber may also be used as needed.

According to one aspect of the present disclosure, there is provided a technique advantageous in reducing the manufacturing cost of a light emitting apparatus having a moisture-resistant ring structure.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A light emitting apparatus comprising:
a polygonal substrate having first and second sides parallel to a first direction and third and fourth sides parallel to a second direction orthogonal to the first direction;
a light emitting element array having a plurality of light emitting elements arranged on the substrate;
a pad arranged on the substrate so as to be located between the first side and the light emitting element array; and
a moisture-resistant ring structure arranged on the substrate,
wherein the moisture-resistant ring structure includes a moisture-resistant wall arranged between the light emitting element array and the first side, and
a shortest distance between the light emitting element array and the moisture-resistant wall in the second direction is smaller than a distance between the light emitting element array and the moisture-resistant wall on a virtual straight line parallel to the second direction and passing through the light emitting element array and the pad.

2. The apparatus according to claim 1, wherein the moisture-resistant ring structure includes a first moisture-resistant ring arranged so as to surround the light emitting element array and the pad, and
the moisture-resistant wall is part of the first moisture-resistant ring.

3. The apparatus according to claim 1, wherein the moisture-resistant ring structure includes a first moisture-resistant ring arranged so as to surround the light emitting element array and the pad and a second moisture-resistant ring arranged so as not to surround the light emitting element array and the pad and so as to be surrounded by the first moisture-resistant ring,
the first moisture-resistant ring includes a portion that defines the distance between the light emitting element array and the moisture-resistant wall on the virtual straight line, and
the second moisture-resistant ring includes a portion that defines the shortest distance between the light emitting element array and the moisture-resistant wall.

4. The apparatus according to claim 1, wherein the moisture-resistant ring structure includes a first moisture-resistant ring arranged so as to surround the light emitting element array and the pad and a second moisture-resistant ring arranged so as not to surround the light emitting element array and the pad and so as to be surrounded by the first moisture-resistant ring,
the first moisture-resistant ring includes a portion that defines the distance between the light emitting element array and the moisture-resistant wall on the virtual straight line, and
at least one of the first moisture-resistant ring and the second moisture-resistant ring includes a portion that defines the shortest distance between the light emitting element array and the moisture-resistant wall.

5. The apparatus according to any one of claims 2 to 4, wherein the first moisture-resistant ring is arranged so as to entirely circumferentially surround the light emitting element array.

6. The apparatus according to claim 3 or 4, wherein the first moisture-resistant ring is arranged so as to entirely circumferentially surround the light emitting element array and the pad, and
the second moisture-resistant ring is arranged so as to entirely circumferentially surround a structure arranged inside the second moisture-resistant ring.

7. The apparatus according to any one of claims 2 to 4, wherein a minimum rectangle circumscribed to the light emitting element array is larger in dimension in the first direction than in the second direction.

8. The apparatus according to any one of claims 2 to 4, wherein each of the plurality of light emitting elements includes a plurality of functional layers including organic materials.

9. The apparatus according to any one of claims 2 to 4, further comprising a plurality of contact regions arranged on the polygonal substrate so as to receive signals or potentials for driving the plurality of light emitting elements,
wherein the moisture-resistant ring structure is arranged on the polygonal substrate so as to suppress infiltration of moisture into the plurality of contact regions in addition to the light emitting element array and the pad.

10. The apparatus according to claim 9, wherein the plurality of contact regions includes a first contact region arranged between the light emitting element array and the first side.

11. The apparatus according to claim 9 or 10, wherein the plurality of contact regions further includes a second contact region arranged between the light emitting element array and the third side, and a third contact region arranged between the light emitting element array and the fourth side.

12. The apparatus according to claim 9 or 10, wherein the portion of the moisture-resistant wall which defines the shortest distance is arranged between the pad and the first contact region in the first direction.

13. The apparatus according to any one of claims 2 to 4, further comprising a second pad arranged on the polygonal substrate so as to be located between the first side and the light emitting element array, and
the portion of the moisture-resistant wall which defines the shortest distance is arranged between the pad and the second pad in the first direction.

14. The apparatus according to any one of claims 2 to 4, further comprising a trace of contact of part of a deposition mask for formation of the plurality of light emitting elements between the moisture-resistant wall and the first side.

15. An image forming apparatus comprising:
a photoconductive body;
a charging unit configured to charge the photoconductive body;
an exposure unit configured to exposure a surface of the photoconductive body to light so as to form an electrostatic latent image on the surface; and
a developing unit configured to develop the electrostatic latent image,
wherein the exposure unit includes a light emitting apparatus defined in claim 1.

16. A manufacturing method of a light emitting apparatus, the method comprising:
preparing a polygonal substrate on which a light emitting element array including a plurality of light emitting elements, a pad, and a moisture-resistant ring structure are arranged, the polygonal substrate having first and second sides parallel to a first direction and third and fourth sides parallel to a second direction orthogonal to the first direction, and the moisture-resistant ring structure being arranged on the polygonal substrate so as to surround the light emitting element array and the pad; and
depositing a formation material for a functional layer on the polygonal substrate by using a deposition mask with a protrusion of the deposition mask contacting with a contact permitted area which are located between the first side and a portion of the moisture-resistant ring,
wherein the pad and the protrusion are located on a line in the first direction.

17. The method according to claim 16, wherein a shortest distance between the light emitting element array and the moisture-resistant ring in the second direction is smaller than a distance between the light emitting element array and the moisture-resistant ring on a virtual straight line parallel to the second direction and passing through the light emitting element array and the pad..

18. The method according to claim 16, wherein the moisture-resistant ring structure includes a first moisture-resistant ring arranged so as to surround the light emitting element array and the pad and a second moisture-resistant ring arranged so as not to surround the light emitting element array and the pad and so as to be surrounded by the first moisture-resistant ring,
the first moisture-resistant ring includes a portion that defines the distance between the light emitting element array and the moisture-resistant wall on the virtual straight line, and
the second moisture-resistant ring includes a portion that defines the shortest distance between the light emitting element array and the moisture-resistant wall.

19. The method according to claim 16, wherein
a plurality of contact regions including a first contact region are arranged on the polygonal substrate so as to receive signals or potentials for driving the plurality of light emitting elements, and
a portion of the moisture-resistant ring, which defines the shortest distance is arranged between the pad and the first contact region in the first direction.

20. The method according to any one of claims 17 to 19, wherein the first moisture-resistant ring is arranged so as to entirely circumferentially surround the light emitting element array.
